# EUROPEAN PATENT APPLICATION

(11) **EP 4 468 333 A1**
(43) Date of publication of application: **27.11.2024**
(21) Application number: 22920479.7
(22) Date of filing: 29.11.2022
(51) Int. Cl.: H01L 23/12, G01M 99/00

(54) **SEMICONDUCTOR DEVICE AND MANUFACTURING METHOD FOR SEMICONDUCTOR DEVICE**

(30) Priority: 17.01.2022 JP 2022004775
(71) Applicant: Sony Semiconductor Solutions Corporation, Atsugi-shi, Kanagawa 243-0014 (JP)
(72) Inventor: FURUHASHI, Takahisa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/043889
(87) International publication number: WO 2023/135959

(57) **Abstract**

In a semiconductor device in which a wire line is covered with a solder resist, ion migration is prevented.

A semiconductor device includes a first wire line, a second wire line, and a solder resist. In the semiconductor device including the first wire line and the second wire line, and the solder resist, the first wire line and the second wire line are wired adjacent to each other. In addition, in the semiconductor device, the solder resist covers each of the first wire line and the second wire line with a gap provided between the first wire line and the second wire line.

## Description

### TECHNICAL FIELD

The present technology relates to a semiconductor device. In detail, the present technology relates to a semiconductor device in which a redistribution line and the like are wired, and a method for manufacturing the semiconductor device.

### BACKGROUND ART

Conventionally, in a device in which a plurality of wire lines are patterned on a substrate, metal of one of a pair of adjacent wire lines is sometimes ionized and moves to the other under a predetermined condition, and this phenomenon is called ion migration. In order to suppress this ion migration, a semiconductor device in which a groove is formed in an insulating film between wire lines has been proposed (see, for example, Patent Document 1). In this semiconductor device, each of the wire lines including between the wire lines is covered with a solder resist.

### CITATION LIST

### PATENT DOCUMENT

Patent Document 1: Japanese Patent Application Laid-Open No. 2016-051834

### SUMMARY OF THE INVENTION

### PROBLEMS TO BE SOLVED BY THE INVENTION

In the above conventional technology, a groove is formed in the insulating film between the wire lines such that movement of ions is restrained and ion migration is suppressed. However, in the above conventional technology, the groove in the insulating film is also filled with the solder resist, and ions sometimes move between the wire lines via the solder resist, and there is a possibility that ion migration may not be sufficiently prevented.

The present technology has been designed in view of such a situation, and an object thereof is to prevent ion migration in a semiconductor device in which a wire line is covered with a solder resist.

### SOLUTIONS TO PROBLEMS

The present technology has been made to solve the above-described problems. A first aspect of the present technology is a semiconductor device including: a first wire line and a second wire line wired adjacent to each other; and a solder resist covering each of the first wire line and the second wire line with a gap provided between the first wire line and the second wire line. This brings about an effect that ion migration is prevented.

In addition, in this first aspect, a first insulating film in which the first wire line and the second wire line are wired, and a substrate covered with the first insulating film may be further included. This brings about an effect that ion migration between the wire lines wired on the insulating film is prevented.

In addition, in this first aspect, the first insulating film may have a plane in which a groove is formed between the first wire line and the second wire line. This brings about an effect that movement of ions over the insulating film is suppressed.

In addition, in this first aspect, the first insulating film may have a plane in which a plurality of grooves is formed between the first wire line and the second wire line. This brings about an effect that movement of ions over the insulating film is suppressed.

In addition, in this first aspect, the first insulating film may have a first plane and a second plane having a step between the first plane and the second plane, the first wire line may be wired on the first plane, and the second wire line may be wired on the second plane. This brings about an effect that movement of ions over the insulating film is suppressed.

In addition, in this first aspect, a projection protruding from the second plane may be formed in a region of the second plane between the first wire line and the second wire line. This brings about an effect that movement of ions over the insulating film is suppressed.

In addition, in this first aspect, a first insulating film in which the first wire line and the second wire line are wired; a third wire line and a fourth wire line; a second insulating film in which the third wire line and the fourth wire line are wired; and an insulating layer formed between the first insulating film and the second insulating film and covering the third wire line and the fourth wire line may be further included. This brings about an effect that the wiring density increases.

In addition, in this first aspect, the gap may include: a lower layer space between the first wire line and the second wire line; and an upper layer space between the third wire line and the fourth wire line, and the second insulating film may further cover the lower layer space. This brings about an effect that the wiring density increases.

In addition, in this first aspect, the gap may be provided between the first wire line and the third wire line that are stacked and the second wire line and the fourth wire line that are stacked, and the second insulating film may be removed from the gap. This brings about an effect that the wiring density increases.

In addition, in this first aspect, the solder resist may include a plurality of layers, and density for each of the plurality of layers may be higher as being closer to the first insulating film. This brings about an effect that performance in preventing diffusion of ions and performance in suppressing stress when wiring metal is expanded by heat are enhanced.

In addition, in this first aspect, each of the first wire line and the second wire line may include a wiring metal, and the wiring metal may include at least one of aluminum, silver, gold, or copper. This brings about an effect that ion migration of aluminum, silver, gold, copper, or the like is prevented.

In addition, in this first aspect, each of the first wire line and the second wire line may include a barrier metal, and the barrier metal may include any of tantalum, tantalum nitride, titanium, or titanium nitride. This brings about an effect that diffusion of the wiring metal is suppressed.

In addition, in this first aspect, a solder ball connected to at least one of the first wire line and the second wire line may be further included, and the solder ball may contain tin. This brings about an effect that the substrate is electrically connected.

In addition, in this first aspect, a first via and a second via may be further included, and a gap may be further provided in the solder resist between the first via and the second via. This brings about an effect that a short circuit between the vias is suppressed.

In addition, a second aspect of the present technology is a method for manufacturing a semiconductor device, the method including: a wiring procedure of wiring a first wire line and a second wire line adjacent to each other; and a covering procedure of providing a gap between the first wire line and the second wire line, and covering each of the first wire line and the second wire line with a solder resist. This brings about an effect that ion migration is prevented.

In addition, in this second aspect, an injection procedure of injecting an underfill from a direction perpendicular to a wiring direction of the first wire line and the second wire line may be further included. This brings about an effect that the underfill does not enter the gap.

### BRIEF DESCRIPTION OF DRAWINGS

Fig. 1 is a cross-sectional view illustrating a configuration example of a semiconductor device in a first embodiment of the present technology.
Fig. 2 is an example of a top view of a silicon substrate before being covered with a solder resist in the first embodiment of the present technology.
Fig. 3 is an example of a top view of the silicon substrate after being covered with the solder resist in the first embodiment of the present technology.
Fig. 4 is a view for explaining a manufacturing process up to electrolytic plating in the first embodiment of the present technology.
Fig. 5 is a view for explaining a manufacturing process up to covering with the solder resist in the first embodiment of the present technology.
Fig. 6 is a flowchart illustrating an example of a manufacturing method in the first embodiment of the present technology.
Fig. 7 is a cross-sectional view illustrating a configuration example of a semiconductor device in a second embodiment of the present technology.
Fig. 8 is a view for explaining a manufacturing process up to film formation for an insulating film in the second embodiment of the present technology.
Fig. 9 is a view for explaining a manufacturing process up to covering with a solder resist in the second embodiment of the present technology.
Fig. 10 is a cross-sectional view illustrating a configuration example of a semiconductor device in a third embodiment of the present technology.
Fig. 11 is a cross-sectional view illustrating a configuration example of a semiconductor device in a fourth embodiment of the present technology.
Fig. 12 is a cross-sectional view illustrating a configuration example of a semiconductor device in a fifth embodiment of the present technology.
Fig. 13 is a cross-sectional view illustrating a configuration example of a semiconductor device in a sixth embodiment of the present technology.
Fig. 14 is a cross-sectional view illustrating a configuration example of a semiconductor device in a seventh embodiment of the present technology.
Fig. 15 is a cross-sectional view illustrating a configuration example of a semiconductor device in an eighth embodiment of the present technology.
Fig. 16 is a block diagram illustrating a schematic configuration example of a vehicle control system.
Fig. 17 is an explanatory diagram illustrating an example of an installation position of an imaging section.
Fig. 18 is a diagram illustrating an example of a schematic configuration of an endoscopic surgery system.
Fig. 19 is a block diagram illustrating an example of a functional configuration of a camera head and a camera control unit (CCU) .

### MODE FOR CARRYING OUT THE INVENTION

Modes for carrying out the present technology (hereinafter, referred to as embodiments) will be described below. The description will be given in the following order.
1. First Embodiment (example in which gap is provided between wire lines)
2. Second Embodiment (example in which groove is formed in insulating film between wire lines and gap is provided between wire lines)
3. Third Embodiment (example in which solder resist is multilayered and gap is provided between wire lines)
4. Fourth Embodiment (example in which step is provided in insulating film and gap is provided between wire lines)
5. Fifth Embodiment (example in which plurality of grooves is formed in insulating film between wire lines and gap is provided between wire lines)
6. Sixth Embodiment (example in which projection is provided in insulating film between wire lines and gap is provided between wire lines)
7. Seventh Embodiment (example in which wiring layer is multilayered and gap is provided between wire lines)
8. Eighth Embodiment (example in which wiring layer is multilayered, gap is provided between wire lines, and insulating film is removed from gap)
9. Application Example to Mobile Body
10. Application Example to Endoscopic Surgery System

### <1. First Embodiment>

### [Configuration Example of Semiconductor Device]

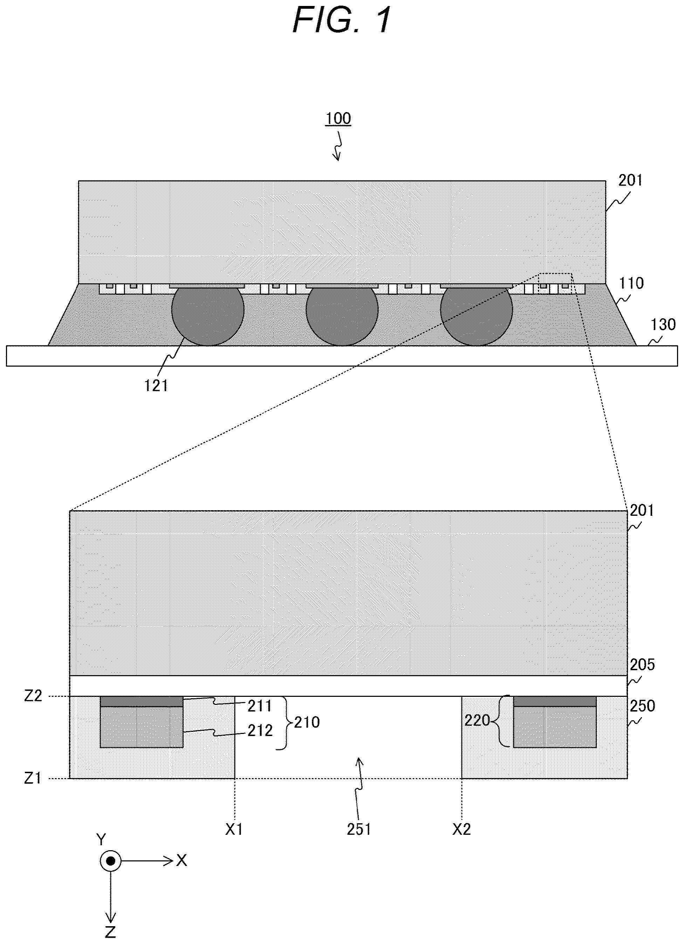

Fig. 1 is a cross-sectional view illustrating a configuration example of a semiconductor device 100 in a first embodiment of the present technology. The semiconductor device 100 includes a silicon substrate 201 and a mounting substrate 130 on which the silicon substrate 201 is mounted. As the semiconductor device 100, for example, an electronic device (such as a digital camera or a smartphone) having an imaging function is supposed. Note that the silicon substrate 201 is an example of a substrate described in the claims.

Hereinafter, a predetermined axis parallel to a substrate plane of the silicon substrate 201 will be assumed as an "X axis", and an axis perpendicular to the substrate plane will be assumed as a "Z axis". An axis perpendicular to the X axis and the Z axis will be assumed as a "Y axis". The drawing is a cross-sectional view when viewed from a Y-axis direction. In addition, the direction from the silicon substrate 201 to the mounting substrate 130 will be assumed as an "upper" direction for convenience.

A predetermined circuit (for example, a circuit functioning as a solid-state imaging element) is formed on the silicon substrate 201. A predetermined number of wire lines such as redistribution lines 210 and 220 are patterned on an upper surface of the silicon substrate 201. In addition, a predetermined number of solder balls 121 are provided on the upper surface of the silicon substrate 201. The silicon substrate 201 is electrically connected to the mounting substrate 130 by these solder balls 121. The solder ball 121 contains, for example, tin.

In addition, an underfill 110 is injected between the silicon substrate 201 and the mounting substrate 130 in order to seal the redistribution lines and the like on the silicon substrate 201.

In addition, the upper surface of the silicon substrate 201 is covered with an insulating film 205 such as a silicon oxynitride film (SiON film). The redistribution lines 210 and 220 are led out to the upper surface through a through silicon via (TSV) or the like and wired on the insulating film 205. Each of the redistribution lines such as the redistribution line 210 includes a wiring metal 212 and a barrier metal 211 for preventing diffusion of the wiring metal 212 into the insulating film 205. Note that the insulating film 205 is an example of a first insulating film described in the claims.

The wiring metal 212 is, for example, any one of aluminum (Al), silver (Ag), gold (Au), and copper (Cu), or an alloy of two or more thereof. That is, the wiring metal 212 contains one or more of Al, Ag, Au, and Cu. For example, a Cu wire line containing Cu as a main component is used as a redistribution line.

In addition, the barrier metal 211 contains, for example, any of tantalum (Ta), tantalum nitride (TaN), titanium (Ti), and titanium nitride (TiN).

In addition, each of the redistribution lines 210 and 220 is covered with a solder resist 250. However, in the solder resist 250, a gap 251 is provided between two adjacent wire lines of the redistribution lines. Note that the redistribution lines 210 and 220 are examples of a first wire line and a second wire line described in the claims.

In the drawing, it is assumed that the redistribution lines 210 and 220 are wired in the Y-axis direction, and these wire lines are adjacent to each other. In this case, the solder resist 250 is not formed between the coordinate X1 on the right side of the redistribution line 210 and the coordinate X2 on the left side of the redistribution line 220 in an X-axis direction, and the insulating film 205 is exposed. On the Z axis, assuming that the coordinate of an upper surface of the solder resist 250 is Z1 and the coordinate of an upper surface of the insulating film 205 is Z2, a rectangle having vertices of (X1, Z1), (X1, Z2), (X2, Z1), and (X2, Z2) corresponds to the cross section of the gap 251. The gap 251 can also be expressed as a "groove" or an "aperture".

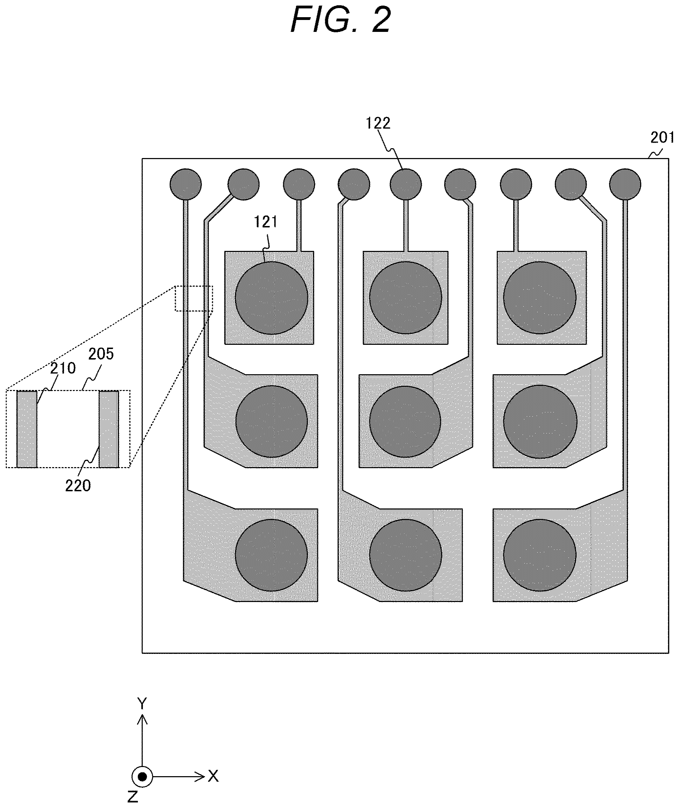

Fig. 2 is an example of a top view of the silicon substrate 201 before being covered with the solder resist 250 in the first embodiment of the present technology. As exemplified in the drawing, a predetermined number of solder balls 121 and a predetermined number of TSVs 122 are formed on the upper surface of the silicon substrate 201. The redistribution lines 210 and 220 are wired on the insulating film 205, and the solder balls 121 and the TSVs 122 are connected by these wire lines. For example, the redistribution lines 210 and 220 are wired adjacent along the Y-axis direction.

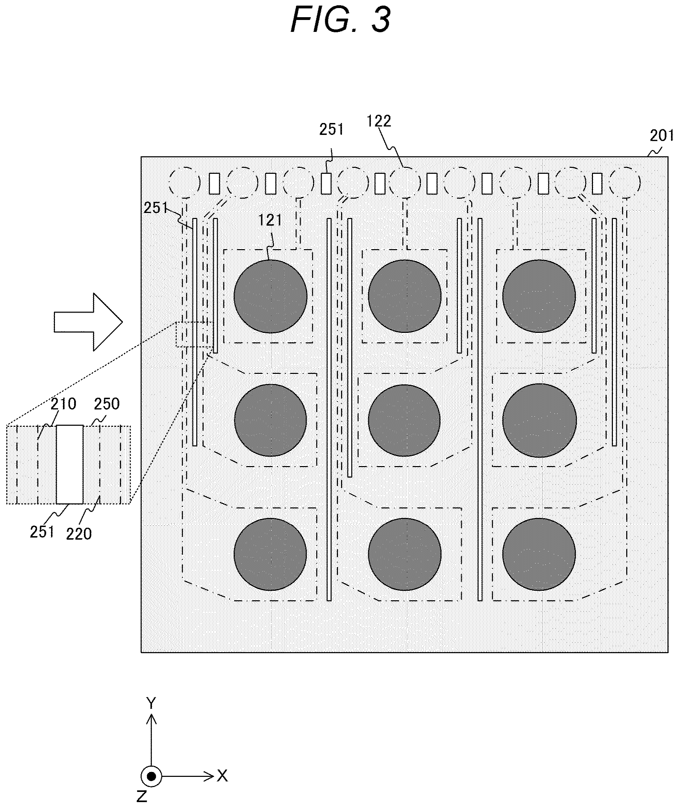

Fig. 3 is an example of a top view of the silicon substrate 201 after being covered with the solder resist 250 in the first embodiment of the present technology. On the upper surface of the silicon substrate 201, the redistribution lines 210 and 220 and the TSVs 122 are covered with the solder resist 250. In the drawing, the dashed-dotted lines indicate the outlines of the redistribution lines and the TSVs 122.

In addition, in the solder resist 250, the gap 251 is formed between two adjacent redistribution lines such as the redistribution lines 210 and 220. In addition, the gap 251 is also formed between two adjacent TSVs 122. In the drawing, the white portions correspond to the gaps 251. By providing the gap 251 without the solder resist 250 between the redistribution lines, when the metal of the redistribution line 210 is ionized, the ions moving in the solder resist 250 and reaching the redistribution line 220 can be suppressed. Therefore, ion migration can be prevented. Note that two adjacent TSVs 122 are examples of a first via and a second via described in the claims.

Here, in order to prevent the underfill 110 from entering the inside of the gap 251, when the underfill 110 is injected, it is preferable to inject the underfill from a direction perpendicular to the wiring direction of the redistribution lines on two sides of the gap 251. For example, in a case where the redistribution lines 210 and 220 on two sides of the gap 251 are wired in the Y-axis direction, the underfill 110 only has to be injected from the X-axis direction. In the drawing, the arrow indicates a direction in which the underfill 110 is injected.

### [Method for Manufacturing Semiconductor Device]

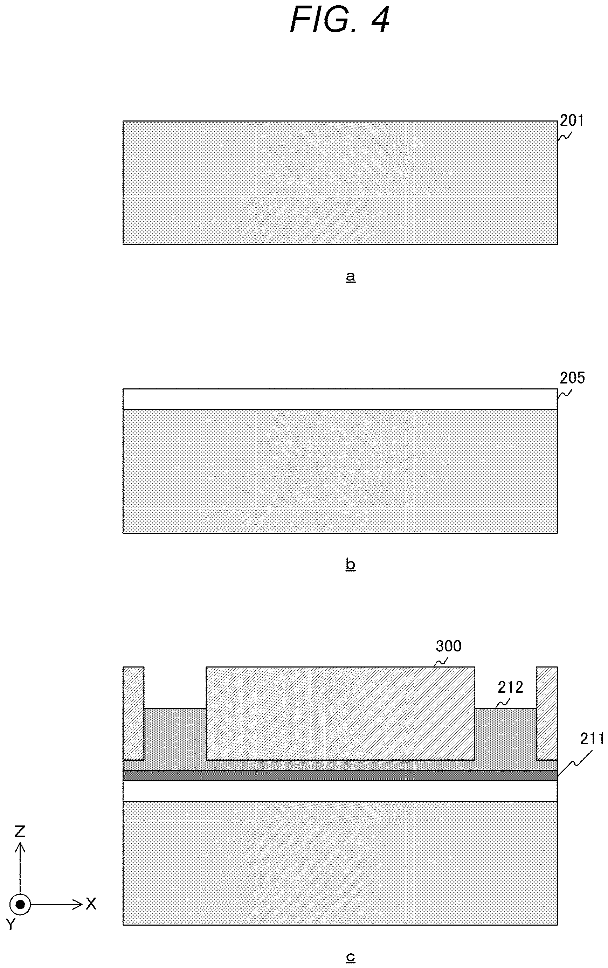

Fig. 4 is a view for explaining a manufacturing process up to electrolytic plating in the first embodiment of the present technology.

As exemplified in a of the drawing, the upper surface of the silicon substrate 201 is flat. As exemplified in b of the drawing, a manufacturing system forms the insulating film 205 on the flat upper surface. Then, as exemplified in c of the drawing, the manufacturing system applies coating with the barrier metal 211 and arranges a photoresist 300 for forming a redistribution line pattern to perform electrolytic plating with the wiring metal 212 (Cu or the like).

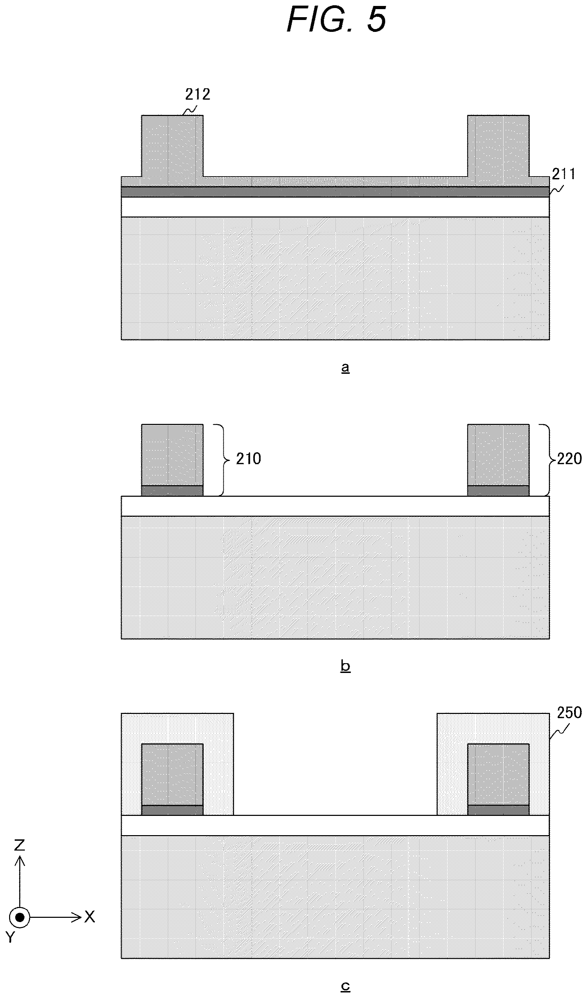

Fig. 5 is a view for explaining a manufacturing process up to covering with the solder resist 250 in the first embodiment of the present technology.

The manufacturing system takes away the barrier metal 211 and the wiring metal 212 at positions other than the wiring pattern by etching from the silicon substrate 201 immediately after the electrolytic plating exemplified in a of the drawing. This forms the redistribution lines 210 and 220 as exemplified in b of the drawing. Then, as exemplified in c of the drawing, the manufacturing system provides a gap between adjacent redistribution lines and covers the redistribution lines 210 and 220 with the solder resist 250.

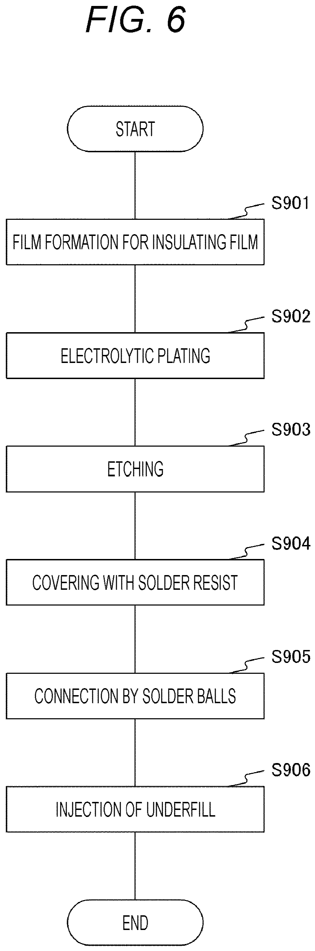

Fig. 6 is a flowchart illustrating an example of the manufacturing method in the first embodiment of the present technology. The manufacturing system forms the insulating film 205 on the upper surface of the silicon substrate 201 (step S901) and performs electrolytic plating (step S902).

Then, the manufacturing system performs etching (step S903) and covers the redistribution lines with the solder resist 250 (step S904). Subsequently, the manufacturing system connects the silicon substrate 201 to the mounting substrate 130 by the solder balls 121 (step S905) and injects the underfill 110 (step S906). After step S906, the manufacturing system executes various processes as necessary and ends the manufacturing process for the semiconductor device 100.

In this manner, according to the first embodiment of the present technology, since the gap 251 is provided between the redistribution lines 210 and 220 and covering with the solder resist 250 is applied, ion migration can be prevented.

### <2. Second Embodiment>

In the first embodiment described above, the upper surfaces of the silicon substrate 201 and the insulating film 205 are flat, but in this configuration, ion migration is likely to occur due to movement of ions over the insulating film 205. A semiconductor device 100 of a second embodiment is different from the semiconductor device 100 of the first embodiment in that a groove is formed between adjacent wire lines on upper surfaces of a silicon substrate 201 and an insulating film 205.

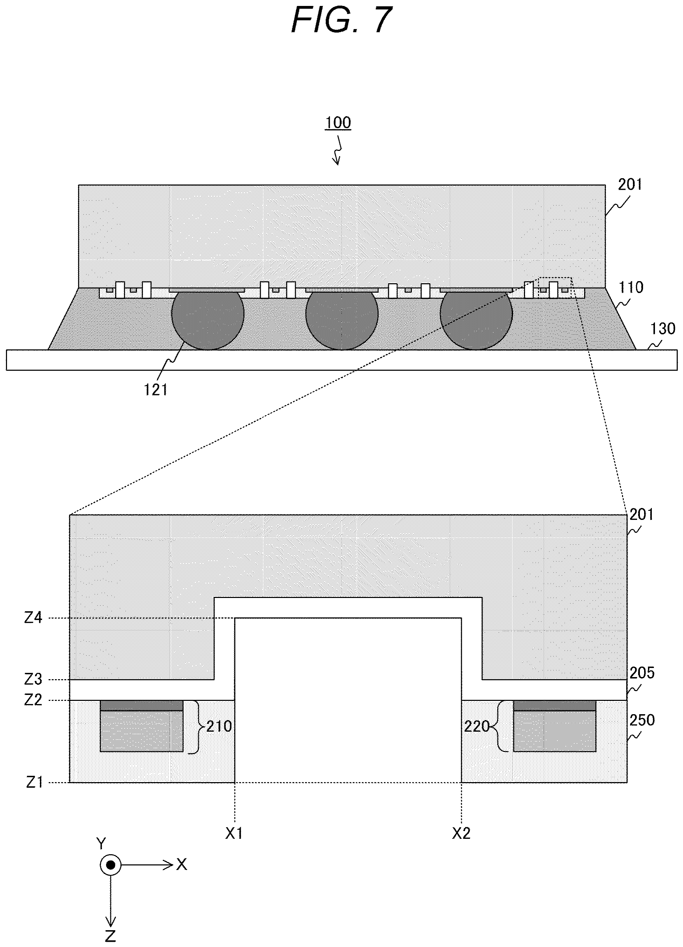

Fig. 7 is a cross-sectional view illustrating a configuration example of the semiconductor device 100 in the second embodiment of the present technology. The semiconductor device 100 of the second embodiment is different from the semiconductor device 100 of the first embodiment in that a groove is formed between adjacent redistribution lines in the silicon substrate 201 and the insulating film 205.

For example, it is assumed that a solder resist 250 is not formed between the coordinate X1 on the right side of a redistribution line 210 and the coordinate X2 on the left side of a redistribution line 220 in the X-axis direction, and the insulating film 205 is exposed. In a Z-axis direction, the coordinate of the upper surface of the solder resist 250 is assumed as Z1, and the coordinate of a lower surface of the solder resist 250 (that is, the upper surface of the insulating film 205) is assumed as Z2. The coordinate of a lower surface of the insulating film 205 immediately below the redistribution lines is assumed as Z3, and the coordinate of a lower surface of the insulating film 205 below Z3 is assumed as Z4. In the drawing, a U-like upside down shape passing through (X1, Z2), (X1, Z4), (X2, Z2), and (X2, Z4) corresponds to the cross section of the groove.

In addition, also in the silicon substrate 201 in a lower layer of the insulating film 205, a groove is formed similarly to the insulating film 205.

By forming a groove between the redistribution lines on the upper surfaces of the silicon substrate 201 and the insulating film 205, when ions of the redistribution line 210 move over the insulating film 205, the movement distance of the ions can be extended to make it difficult for the ions to reach the redistribution line 220. In addition, by forming the groove, a short circuit between the redistribution lines can be suppressed, and time dependent dielectric breakdown (TDDB) can be improved. Furthermore, by forming the groove, the capacitance between the redistribution lines can be reduced.

Note that, in the drawing, the position of a side surface of the solder resist 250 and the position of a side surface of the groove of the insulating film 205 are aligned (in other words, flush), but a configuration in which these positions are not flush with each other is also possible.

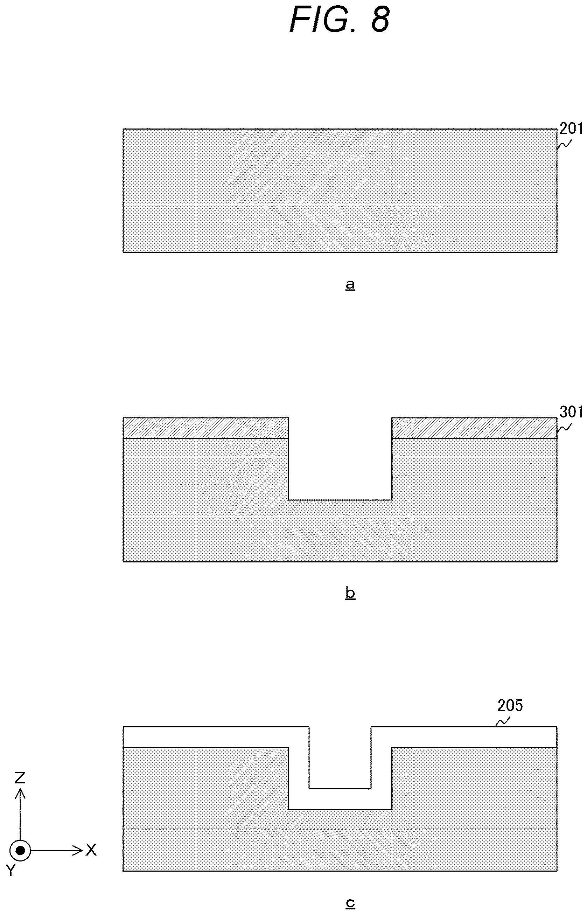

Fig. 8 is a view for explaining a manufacturing process up to film formation for the insulating film 205 in the second embodiment of the present technology.

As exemplified in a of the drawing, the upper surface of the silicon substrate 201 is flat in an initial state. As exemplified in b of the drawing, a manufacturing system arranges a photoresist 301 for forming a groove pattern on the flat upper surface and performs photolithography and dry etching. Then, the manufacturing system removes the photoresist 301 and forms the insulating film 205 as exemplified in c of the drawing.

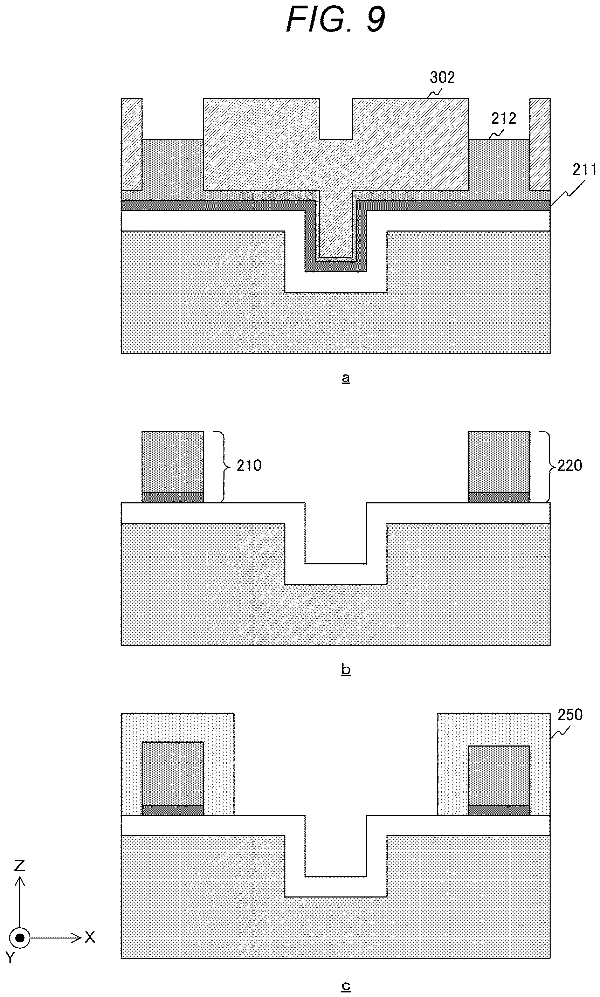

Fig. 9 is a view for explaining a manufacturing process up to covering with the solder resist in the second embodiment of the present technology. As exemplified in a of the drawing, the manufacturing system applies coating with a barrier metal 211 and arranges a photoresist 302 for forming a redistribution line pattern to perform electrolytic plating with a wiring metal 212. As exemplified in b of the drawing, the manufacturing system takes away the barrier metal 211 and the wiring metal 212 at positions other than the wiring pattern by etching. Then, as exemplified in c of the drawing, the manufacturing system provides a gap between adjacent redistribution lines and covers the redistribution lines 210 and 220 with the solder resist 250. In the drawing, c exemplifies a case where a side surface of the solder resist 250 and a side surface of the insulating film 205 are not made flush with each other.

In this manner, according to the second embodiment of the present technology, since the groove is formed between the redistribution lines in the silicon substrate 201 and the insulating film 205, ions moving over the insulating film 205 can be suppressed.

### <3. Third Embodiment>

In the second embodiment described above, the solder resist 250 has a single layer, but in this configuration, performance in preventing diffusion of ions and performance in suppressing stress when the wiring metal 212 is expanded by heat are sometimes insufficient. A semiconductor device 100 in a third embodiment is different from the semiconductor device 100 of the second embodiment in that a solder resist 250 has multiple layers.

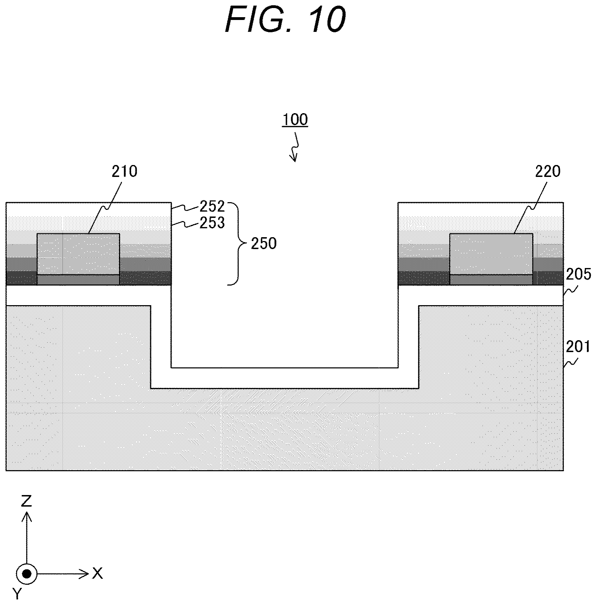

Fig. 10 is a cross-sectional view illustrating a configuration example of the semiconductor device 100 in the third embodiment of the present technology. The semiconductor device 100 of the third embodiment is different from the semiconductor device 100 of the second embodiment in that the solder resist 250 includes a plurality of layers such as an upper layer 252 and a middle layer 253. These layers are stacked in the Z-axis direction. The density for each of these layers is assumed to be higher as being closer to an insulating film 205. In the drawing, the depth of color of the layer in the solder resist 250 indicates the level of density.

By increasing the density as being closer to the insulating film 205, performance in preventing re-nucleation of ions of the wiring metal 212 (Cu or the like) can be further enhanced in a layer closer to the insulating film 205. In addition, in a layer farther from the insulating film 205, stress when the wiring metal 212 is expanded by heat can be further reduced.

Note that the third embodiment can be applied to the first embodiment without a groove.

In this manner, according to the third embodiment of the present technology, since the solder resist 250 has multiple layers, performance in preventing diffusion of ions and performance in suppressing stress when the wiring metal 212 is expanded by heat can be enhanced.

### <4. Fourth Embodiment>

In the first embodiment described above, the upper surfaces of the silicon substrate 201 and the insulating film 205 are flat, but in this configuration, performance in preventing ion migration is sometimes insufficient. A semiconductor device 100 in a fourth embodiment is different from the semiconductor device 100 of the first embodiment in that a step is provided in a silicon substrate 201 and an insulating film 205.

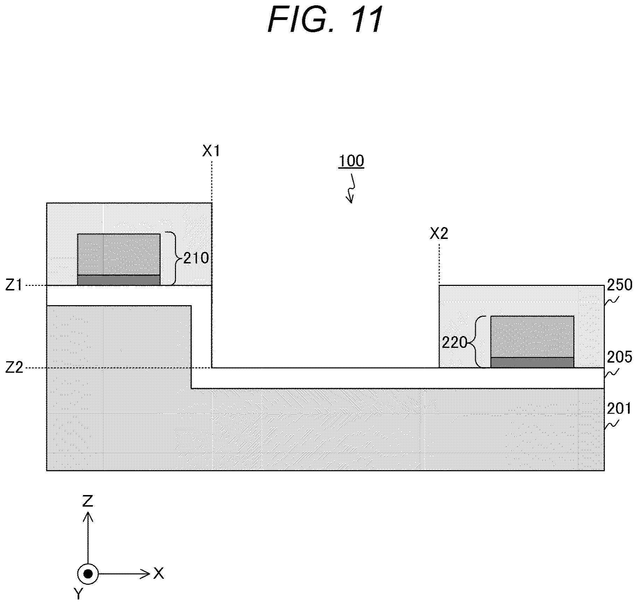

Fig. 11 is a cross-sectional view illustrating a configuration example of the semiconductor device 100 in the fourth embodiment of the present technology. The semiconductor device 100 of the fourth embodiment is different from the semiconductor device 100 of the first embodiment in that a step is provided on an upper side of the silicon substrate 201 and the insulating film 205.

For example, the Z coordinate of an upper surface of the insulating film 205 is Z1 on the left side of X1, but is Z2 on the right side of X1. In other words, the insulating film 205 has two planes having a step between the two planes. An upper surface of the insulating film 205 on the left side of X1 in the drawing is an example of a first plane described in the claims. An upper surface of the insulating film 205 on the right side of X1 is an example of a second plane described in the claims.

Similarly to the insulating film 205, a step is also provided on an upper surface of the silicon substrate 201.

In addition, a redistribution line 210 is wired on one of the two planes having the step between the two planes, and a redistribution line 220 is wired on the other of these planes. This makes the heights of the redistribution lines 210 and 220 from a predetermined plane different from each other. By varying the heights of the adjacent redistribution lines 210 and 220, the electric field between the redistribution lines 210 and 220 can be weakened to enhance performance in preventing ion migration. In addition, by varying the heights, the distance between the redistribution lines can be lengthened to prevent a short circuit due to ion migration.

Note that the third embodiment can be applied to the fourth embodiment.

In this manner, according to the fourth embodiment of the present technology, since the step is provided in the insulating film 205, the heights of the redistribution lines 210 and 220 can be varied. This can enhance performance in preventing ion migration.

### <5. Fifth Embodiment>

In the first embodiment described above, the upper surfaces of the silicon substrate 201 and the insulating film 205 are flat, but in this configuration, ion migration is likely to occur due to movement of ions over the insulating film 205. A semiconductor device 100 of a fifth embodiment is different from the semiconductor device 100 of the first embodiment in that a plurality of grooves is formed between adjacent wire lines on upper surfaces of a silicon substrate 201 and an insulating film 205.

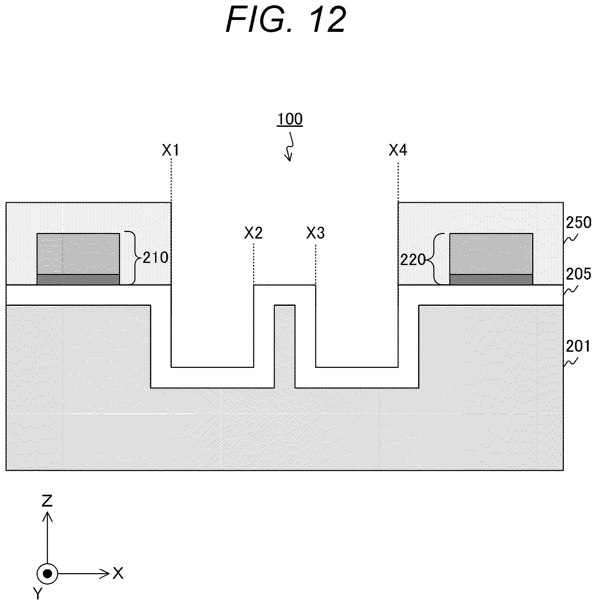

Fig. 12 is a cross-sectional view illustrating a configuration example of the semiconductor device 100 in the fifth embodiment of the present technology. The semiconductor device 100 of the fifth embodiment is different from the semiconductor device 100 of the first embodiment in that two grooves are formed between redistribution lines 210 and 220 in the silicon substrate 201 and the insulating film 205. For example, in a case where a gap is provided between the wire lines from the coordinate X1 to the coordinate X4, a first groove is formed from the coordinate X1 to the coordinate X2, and a second groove is formed from the coordinate X3 to the coordinate X4. Note that the number of grooves between the wire lines is not limited to two and may be three or more. By employing two or more grooves, the movement distance of ions can be extended as compared with a case where there is one groove, and ions reaching one of the redistribution lines 210 and 220 can be suppressed.

Note that the third embodiment can be applied to the fifth embodiment.

In this manner, according to the fifth embodiment of the present technology, since the plurality of grooves is formed between the redistribution lines, ions moving over the insulating film 205 can be suppressed.

### <6. Sixth Embodiment>

In the first embodiment described above, the upper surfaces of the silicon substrate 201 and the insulating film 205 are flat, but in this configuration, performance in preventing ion migration is sometimes not sufficient. A semiconductor device 100 in a sixth embodiment is different from the semiconductor device 100 of the first embodiment in that a step is provided in a silicon substrate 201 and an insulating film 205, and a projection is further provided between the redistribution lines.

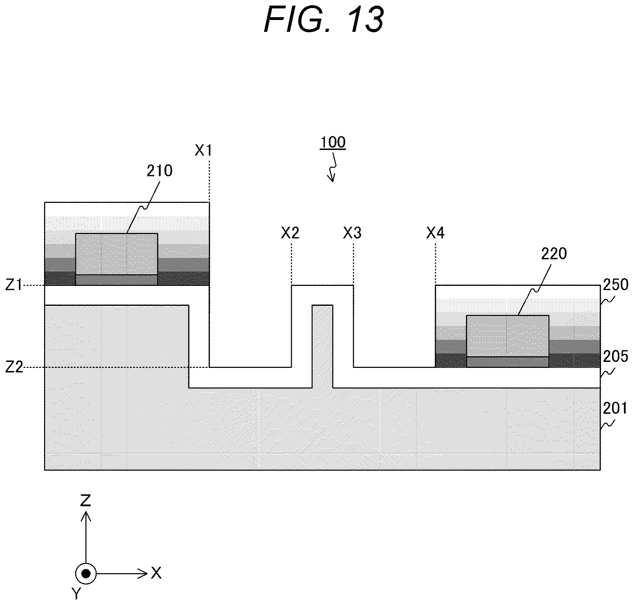

Fig. 13 is a cross-sectional view illustrating a configuration example of the semiconductor device 100 in the sixth embodiment of the present technology. The semiconductor device 100 of the sixth embodiment is different from the semiconductor device 100 of the first embodiment in that a step is provided in the silicon substrate 201 and the insulating film 205, and a projection is further provided between redistribution lines 210 and 220. In addition, the semiconductor device 100 of the sixth embodiment is different from the semiconductor device 100 of the first embodiment in that a solder resist 250 is multilayered.

For example, the Z coordinate of an upper surface of the insulating film 205 is Z1 on the left side of X1, but is Z2 on the right side of X1. In addition, in a case where a gap is provided between the wire lines from the coordinate X1 to the coordinate X4, a projection protruding from an X-Y plane at the coordinate Z1 is provided from the coordinate X2 to the coordinate X3. By providing the projection between the redistribution lines 210 and 220, the movement distance of ions can be extended, and ions reaching one of the redistribution lines 210 and 220 can be suppressed.

Note that only one projection is provided between the redistribution lines, but two or more projections can also be provided. In addition, the solder resist 250 is multilayered, but can have a single layer.

In this manner, according to the sixth embodiment of the present technology, since the step is provided in the insulating film 205 and the projection is formed between the redistribution lines, ions moving over the insulating film 205 can be suppressed.

### <7. Seventh Embodiment>

In the first embodiment described above, the layer for the redistribution lines 210 and 220 is constituted as a single layer, but in this configuration, the wiring density is sometimes insufficient. A semiconductor device 100 in a sixth embodiment is different from the semiconductor device 100 of the first embodiment in that the layer for the redistribution lines is multilayered.

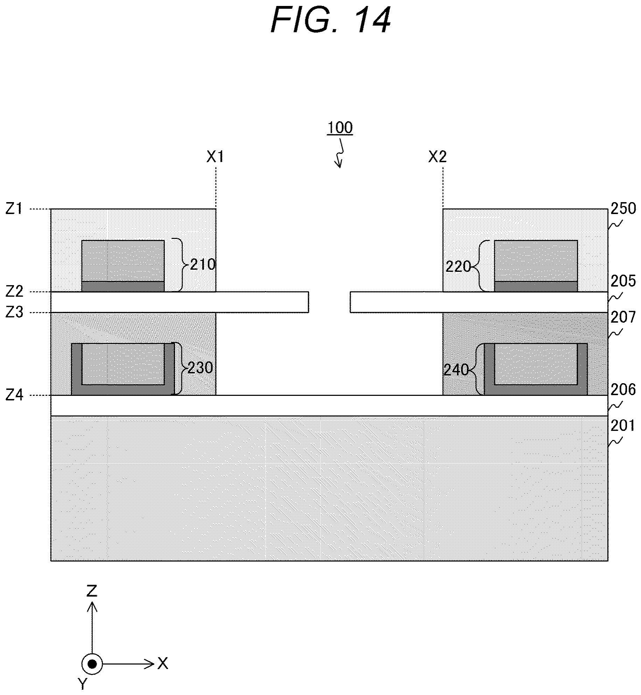

Fig. 14 is a cross-sectional view illustrating a configuration example of the semiconductor device 100 in the seventh embodiment of the present technology. The semiconductor device 100 of the seventh embodiment is different from the semiconductor device 100 of the first embodiment in that there are two redistribution layers. The redistribution layer on a lower side includes redistribution lines 230 and 240, which are wired on an upper surface of an insulating film 206 and covered with an insulating layer 207. As a material of the insulating layer 207, SiO, SiN, SiON, or the like is used. In addition, in the redistribution lines 230 and 240 on the lower side, the barrier metal is also formed on side surfaces of the wire lines. In the insulating layer 207 on the lower side, a gap is provided between the redistribution lines 210 and 220. This gap will be referred to as a "lower layer space".

The insulating layer 207 and an upper surface of the lower layer space are covered with an insulating film 205. However, in order to form the lower layer space by wet etching or the like to produce a hollow structure, a part of the insulating film 205 is removed by dry or wet etching to form a hole. Note that the insulating film 206 is an example of a second insulating film described in the claims.

The redistribution layer on an upper side includes redistribution lines 210 and 220, which are wired on an upper surface of the insulating film 205 and covered with a solder resist 250. In the solder resist 250 on the upper side, a gap is provided between the redistribution lines 210 and 220. This gap will be referred to as an "upper layer space". Note that the redistribution lines 230 and 240 are examples of a third wire line and a fourth wire line described in the claims.

For example, the Z coordinate of the upper surface of the solder resist 250 is assumed as Z1, and the Z coordinate of a lower surface of the solder resist 250 is assumed as Z2. The Z coordinate of the upper surface of the insulating layer 207 is assumed as Z3, and the Z coordinate of a lower surface of the insulating layer 207 is assumed as Z4. In a case where a gap is provided between the wire lines from the coordinate X1 to the coordinate X2, a rectangle having vertices of (X1, Z3), (X1, Z4), (X2, Z3), and (X2, Z4) corresponds to the cross section of the lower layer space. In addition, a rectangle having vertices of (X1, Z1), (X1, Z2), (X2, Z1), and (X2, Z2) corresponds to the cross section of the upper layer space.

Note that the redistribution layer has two layers in the drawing, but can also have three or more layers. In addition, each of the second, third, fourth, fifth, and sixth embodiments can be applied to the seventh embodiment.

In this manner, according to the seventh embodiment of the present technology, since the redistribution layer has multiple layers, the wiring density can be increased.

### <8. Eighth Embodiment>

In the seventh embodiment described above, the redistribution layer has a hollow structure when multilayered, but in this configuration, a process of forming the lower layer space by making a hole in the insulating film 205 on the upper side is required. A semiconductor device 100 in an eighth embodiment is different from the semiconductor device 100 of the seventh embodiment in that an insulating film 205 is removed from a gap between wire lines.

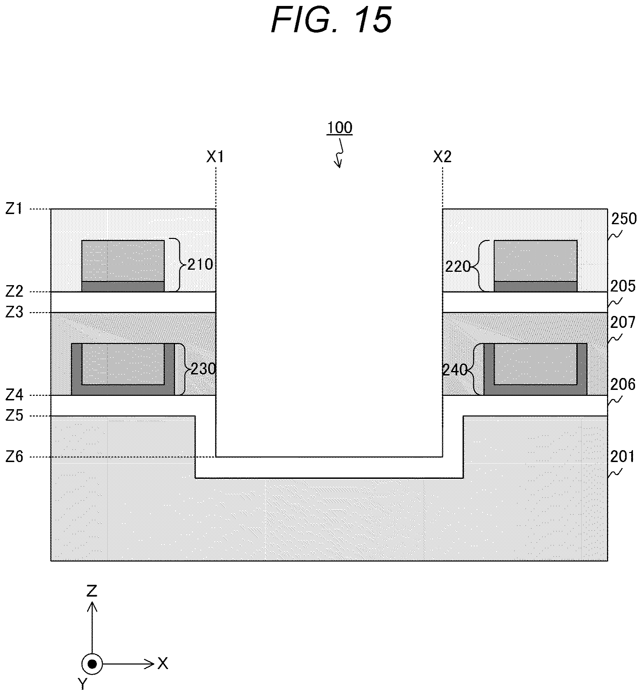

Fig. 15 is a cross-sectional view illustrating a configuration example of the semiconductor device 100 in the eighth embodiment of the present technology. The semiconductor device 100 of the eighth embodiment is different from the semiconductor device 100 of the seventh embodiment in that the insulating film 205 is removed from a gap between wire lines, and a groove is formed in an insulating film 206 on a lower side and a silicon substrate 201. By removing the insulating film 205 from the gap between the wire lines, a hollow structure is no longer required.

The Z coordinate of a lower surface of the insulating film 206 immediately below an insulating layer 207 is assumed as Z5, and the coordinate of a lower surface of the insulating film 206 below Z5 is assumed as Z6. In the drawing, a U-like shape passing through (X1, Z4), (X1, Z6), (X2, Z4), and (X2, Z6) corresponds to the cross section of the groove.

Note that a configuration with no groove formed in the insulating film 206 on the lower side and the silicon substrate 201 is also possible. In addition, the redistribution layer has two layers in the drawing, but can also have three or more layers. In addition, each of the third, fourth, fifth, and sixth embodiments can be applied to the eighth embodiment.

In this manner, according to the eighth embodiment of the present technology, since the insulating film 205 is removed from the gap between the wire lines, a hollow structure is no longer required. In addition, since the groove is formed between the redistribution lines in the silicon substrate 201 and the insulating film 206, ions moving over the insulating film 206 can be suppressed.

### <9. Application Example to Mobile Body>

The technology according to the present disclosure (the present technology) is applicable to various products. For example, the technology according to the present disclosure may be implemented as a device mounted on any type of mobile body such as an automobile, an electric vehicle, a hybrid electric vehicle, a motorcycle, a bicycle, a personal mobility, an airplane, a drone, a ship, or a robot.

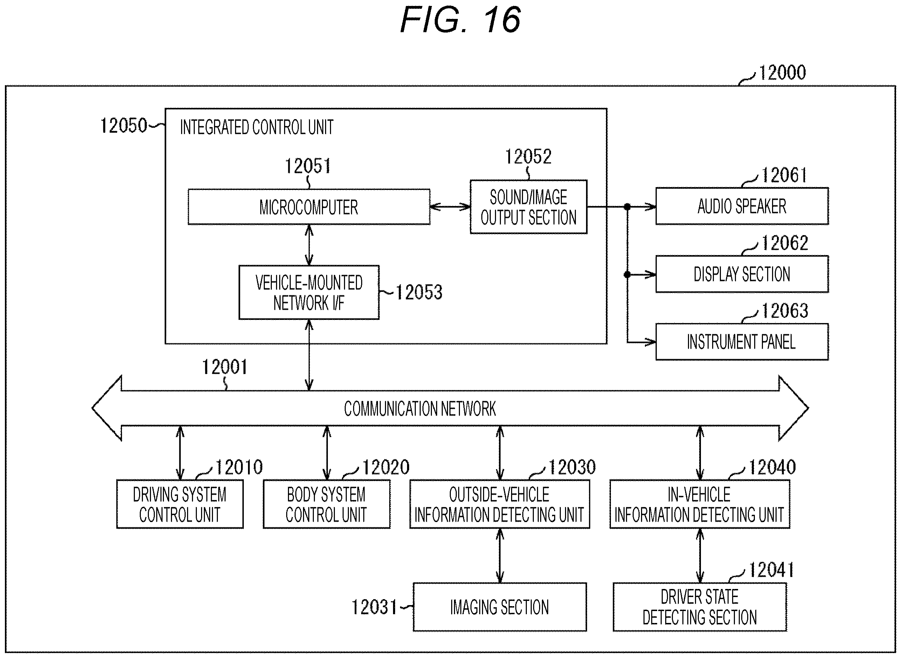

Fig. 16 is a block diagram illustrating a schematic configuration example of a vehicle control system as an example of a mobile body control system to which the technology according to the present disclosure can be applied.

The vehicle control system 12000 includes a plurality of electronic control units connected to each other via a communication network 12001. In the example illustrated in Fig. 16, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are depicted as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 16, an audio speaker 12061, a display section 12062, and an instrument panel 12063 are exemplified as the output devices. The display section 12062 may, for example, include at least one of an on-board display and a head-up display.

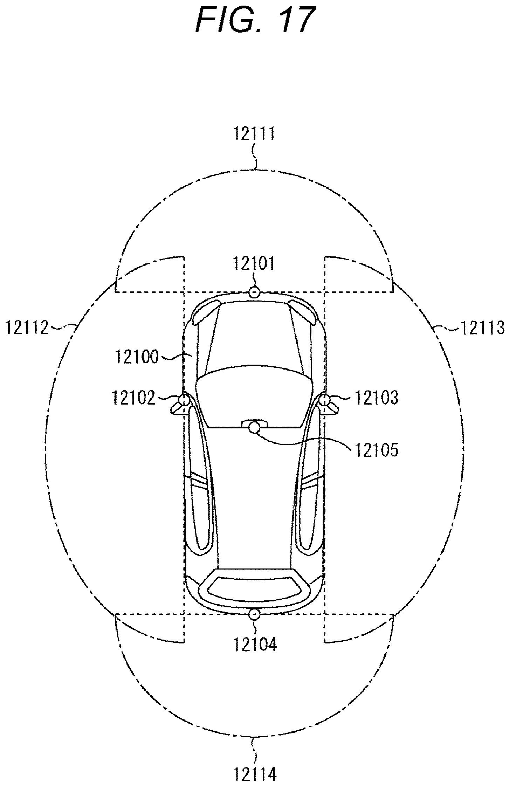

Fig. 17 is a diagram illustrating an example of an installation position of the imaging section 12031.

In Fig. 17, the imaging section 12031 includes imaging sections 12101, 12102, 12103, 12104, and 12105.

The imaging sections 12101, 12102, 12103, 12104, and 12105 are, for example, provided at positions on a front nose, sideview mirrors, a rear bumper, and a back door of the vehicle 12100 as well as a position on an upper portion of a windshield within the interior of the vehicle, and the like. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 17 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to, for example, the imaging section 12031 among the constituents described above. Specifically, the semiconductor device 100 in Fig. 1 can be applied to the imaging section 12031. By applying the technology according to the present disclosure to the imaging section 12031, ion migration can be prevented, and the reliability of the system can be enhanced.

### <10. Application Example to Endoscopic Surgery System>

The technology according to the present disclosure (the present technology) is applicable to various products. For example, the technology according to the present disclosure may be applied to an endoscopic surgery system.

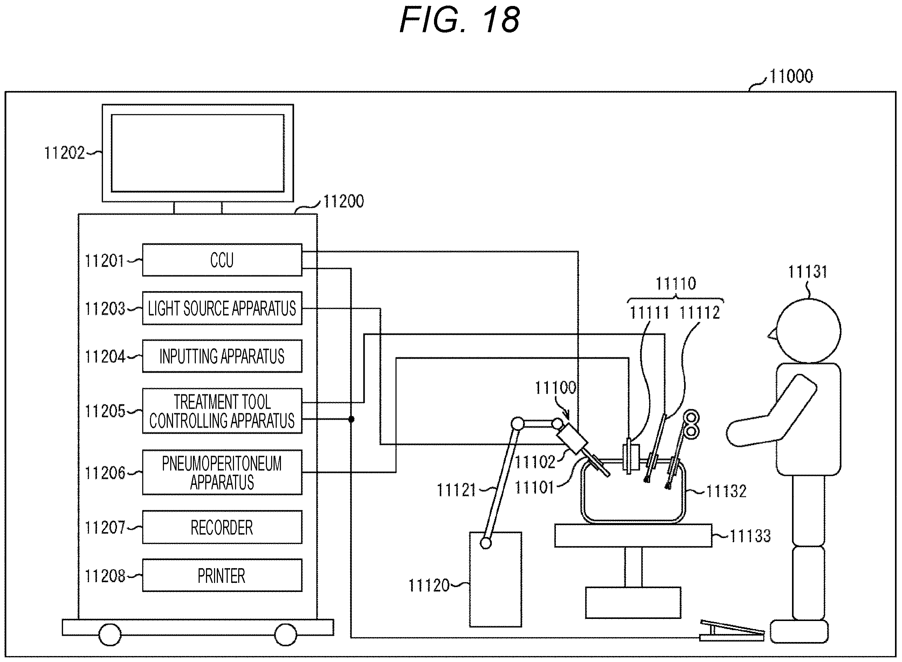

Fig. 18 is a view illustrating an example of a schematic configuration of an endoscopic surgery system to which the technology according to an embodiment of the present disclosure (present technology) can be applied.

In Fig. 18, a state is depicted in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

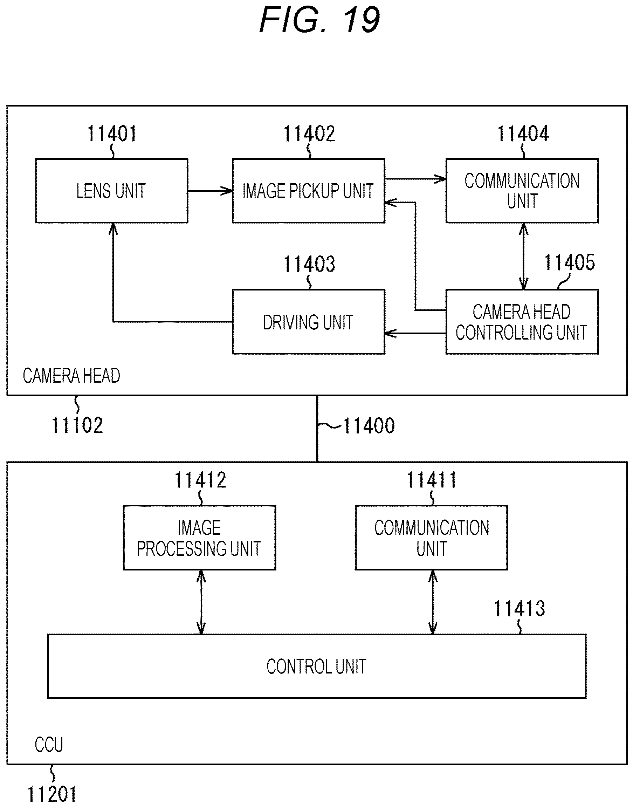

Fig. 19 is a block diagram illustrating an example of a functional configuration of the camera head 11102 and the CCU 11201 illustrated in Fig. 18.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to the image pickup unit 11402 among the constituents described above. Specifically, the semiconductor device 100 in Fig. 1 can be applied to the image pickup unit 10402. By applying the technology according to the present disclosure to the image pickup unit 11402, ion migration can be prevented, and the reliability of the system can be enhanced.

Note that an endoscopic surgery system has been described as an example herein, but the technology according to the present disclosure may be applied to a microscopic surgery system or the like, for example.

Note that the embodiments described above show examples for embodying the present technology, and the respective matters in the embodiments and the respective matters specifying the invention in the claims have correspondence relationships. Similarly, the respective matters specifying the invention in the claims and the respective matters with the same names in the embodiments of the present technology have correspondence relationships. However, the present technology is not limited to the embodiments and can be embodied by applying various modifications to the embodiments without departing from the gist of the present technology.

Note that advantageous effects described in the present description are merely examples and are not limited, and other advantageous effects may be provided.

Note that the present technology can also have the following configuration.
(1) A semiconductor device including:
   a first wire line and a second wire line wired adjacent to each other; and
   a solder resist covering each of the first wire line and the second wire line with a gap provided between the first wire line and the second wire line.
(2) The semiconductor device according to (1) above, further including:
   a first insulating film in which the first wire line and the second wire line are wired; and
   a substrate covered with the first insulating film.
(3) The semiconductor device according to (2) above, in which
   the first insulating film has a plane in which a groove is formed between the first wire line and the second wire line.
(4) The semiconductor device according to (2) above, in which
   the first insulating film has a plane in which a plurality of grooves is formed between the first wire line and the second wire line.
(5) The semiconductor device according to any one of (2) to (4) above, in which
   the first insulating film has a first plane and a second plane having a step between the first plane and the second plane,
   the first wire line is wired on the first plane, and
   the second wire line is wired on the second plane.
(6) The semiconductor device according to (5) above, in which
   a projection protruding from the second plane is formed in a region of the second plane between the first wire line and the second wire line.
(7) The semiconductor device according to (1) above, further including:
   a first insulating film in which the first wire line and the second wire line are wired;
   a third wire line and a fourth wire line;
   a second insulating film in which the third wire line and the fourth wire line are wired; and
   an insulating layer formed between the first insulating film and the second insulating film and covering the third wire line and the fourth wire line.
(8) The semiconductor device according to (7) above, in which
   the gap includes a lower layer space between the first wire line and the second wire line and an upper layer space between the third wire line and the fourth wire line, and
   the second insulating film further covers the lower layer space.
(9) The semiconductor device according to (7) above, in which
   the gap is provided between the first wire line and the third wire line that are stacked and the second wire line and the fourth wire line that are stacked, and
   the second insulating film is removed from the gap.
(10) The semiconductor device according to any one of (1) to (9) above, in which
   the solder resist includes a plurality of layers, and
   density for each of the plurality of layers is higher as being closer to the first insulating film.
(11) The semiconductor device according to any one of (1) to (10) above, in which
   each of the first wire line and the second wire line includes a wiring metal, and
   the wiring metal includes at least one of aluminum, silver, gold, or copper.
(12) The semiconductor device according to any one of (1) to (11) above, in which
   each of the first wire line and the second wire line includes a barrier metal, and
   the barrier metal includes any of tantalum, tantalum nitride, titanium, or titanium nitride.
(13) The semiconductor device according to any one of (1) to (12) above, further including
   a solder ball connected to at least one of the first wire line and the second wire line, in which
   the solder ball contains tin.
(14) The semiconductor device according to any one of (1) to (13) above, further including
   a first via and a second via, in which
   a gap is further provided in the solder resist between the first via and the second via.
(15) A method for manufacturing a semiconductor device, the method including:
   a wiring procedure of wiring a first wire line and a second wire line adjacent to each other; and
   a covering procedure of providing a gap between the first wire line and the second wire line, and covering each of the first wire line and the second wire line with a solder resist.
(16) The method for manufacturing the semiconductor device according to (15) above, the method further including
   an injection procedure of injecting an underfill from a direction perpendicular to a wiring direction of the first wire line and the second wire line.

### REFERENCE SIGNS LIST

100 Semiconductor device
110 Underfill
121 Solder ball
122 TSV
130 Mounting substrate
201 Silicon substrate
205, 206 Insulating film
207 Insulating layer
210, 220, 230, 240 Redistribution line
211 Barrier metal
212 Wiring metal
250 Solder resist
251 Gap
252 Upper layer
253 Middle layer
300, 301 Photoresist
11402, 12031 Image pickup unit, Imaging section

## Claims

1. A semiconductor device comprising:
a first wire line and a second wire line wired adjacent to each other; and
a solder resist covering each of the first wire line and the second wire line with a gap provided between the first wire line and the second wire line.

2. The semiconductor device according to claim 1, further comprising:
a first insulating film in which the first wire line and the second wire line are wired; and
a substrate covered with the first insulating film.

3. The semiconductor device according to claim 2, wherein
the first insulating film has a plane in which a groove is formed between the first wire line and the second wire line.

4. The semiconductor device according to claim 2, wherein
the first insulating film has a plane in which a plurality of grooves is formed between the first wire line and the second wire line.

5. The semiconductor device according to claim 2, wherein
the first insulating film has a first plane and a second plane having a step between the first plane and the second plane,
the first wire line is wired on the first plane, and
the second wire line is wired on the second plane.

6. The semiconductor device according to claim 5, wherein
a projection protruding from the second plane is formed in a region of the second plane between the first wire line and the second wire line.

7. The semiconductor device according to claim 1, further comprising:
a first insulating film in which the first wire line and the second wire line are wired;
a third wire line and a fourth wire line;
a second insulating film in which the third wire line and the fourth wire line are wired; and
an insulating layer formed between the first insulating film and the second insulating film and covering the third wire line and the fourth wire line.

8. The semiconductor device according to claim 7, wherein
the gap includes a lower layer space between the first wire line and the second wire line and an upper layer space between the third wire line and the fourth wire line, and
the second insulating film further covers the lower layer space.

9. The semiconductor device according to claim 7, wherein
the gap is provided between the first wire line and the third wire line that are stacked and the second wire line and the fourth wire line that are stacked, and
the second insulating film is removed from the gap.

10. The semiconductor device according to claim 1, wherein
the solder resist includes a plurality of layers, and density for each of the plurality of layers is higher as being closer to the first insulating film.

11. The semiconductor device according to claim 1, wherein
each of the first wire line and the second wire line includes a wiring metal, and
the wiring metal includes at least one of aluminum, silver, gold, or copper.

12. The semiconductor device according to claim 1, wherein
each of the first wire line and the second wire line includes a barrier metal, and
the barrier metal includes any of tantalum, tantalum nitride, titanium, or titanium nitride.

13. The semiconductor device according to claim 1, further comprising
a solder ball connected to at least one of the first wire line and the second wire line, wherein
the solder ball contains tin.

14. The semiconductor device according to claim 1, further comprising
a first via and a second via, wherein
a gap is further provided in the solder resist between the first via and the second via.

15. A method for manufacturing a semiconductor device, the method comprising:
a wiring procedure of wiring a first wire line and a second wire line adjacent to each other; and
a covering procedure of providing a gap between the first wire line and the second wire line, and covering each of the first wire line and the second wire line with a solder resist.

16. The method for manufacturing the semiconductor device according to claim 15, the method further comprising
an injection procedure of injecting an underfill from a direction perpendicular to a wiring direction of the first wire line and the second wire line.
